# EUROPEAN PATENT APPLICATION

(11) **EP 3 045 883 A1**
(43) Date of publication of application: **20.07.2016**
(21) Application number: 16151438.5
(22) Date of filing: 15.01.2016
(51) Int. Cl.: G01H 1/00, G01R 31/00, G01R 31/28, H01R 13/66, H01R 39/08

(54) **SENSOR SIMULATOR AND SYSTEM FOR TESTING ROTATABLE SENSOR SIGNAL TRANSMITTERS**

(30) Priority: 19.01.2015 US 201514599590
(71) Applicant: General Electric Company, Schenectady, NY 12345 (US)
(72) Inventor: SCHLEIF, Kurt Kramer, Greenville, SC South Carolina 29615 (US); SHAW, Donald W., Greenville, SC South Carolina 29615 (US); SNIDER, Zachary John, Greenville, SC South Carolina 29615 (US); ARCENEAUX, Mario Joseph, Greenville, SC South Carolina 29615 (US)
(74) Representative: Lee, Brenda

(57) **Abstract**

A sensor simulator 100 and a system for testing rotatable sensor signal transmitters using the sensor simulator is disclosed herein. The sensor simulator includes a first 114 and a second 116 pin. The first pin includes a first end portion 118 and a second end portion 120 where the first end portion is configured to electronically couple to a positive terminal 42 of a sensor circuit of the sensor signal transmitter. The second pin 116 includes a first end portion 122 and a second end portion 124 where the first end portion is configured to electronically couple to a negative terminal 44 of the same sensor circuit. The sensor simulator further includes an electronic component having a first wire lead electronically coupled to the second end portion of the first pin and a second wire lead electronically coupled the second end portion of the second pin.

## Description

### FIELD OF THE INVENTION

The present invention generally involves a sensor simulator. In particular, the present invention involves a system for testing a rotatable sensor signal transmitter that includes a sensor simulator.

### BACKGROUND OF THE INVENTION

Turbomachines such as wind turbines, gas turbines, steam turbines, pumps, fans, generators, motors, and other forms of commercial equipment frequently include shafts, blades, and other rotating components. It is known in the art to install one or more sensors on the rotating components to measure various characteristics of those components in order to control, monitor, and/or enhance the operation of the rotating components. For example, sensors that measure temperature, velocity, stress, strain, vibrations, and/or other characteristics of the rotating components may allow for early detection of abnormalities, adjustments to repair or maintenance schedules, and/or other actions to enhance operations.

Various slip ring and telemetry systems exist in the art for transmitting the analogue sensor data from the rotating components to stator components for further analysis. One system employs a plurality of sensor signal transmitters annularly arranged within a carrier shaft that is configured to couple to an end of a turbomachine rotor shaft. Each of the sensor signal transmitters includes multi-pin connectors having multiple terminal pairs of pins that are electronically coupled to individual sensor circuits defined within the sensor signal transmitters. The sensor signal transmitters receive discrete analogue signals from the sensors, process the signals and transmit the processed signals to a data acquisition system via a slip ring assembly. The sensor signal transmitters may also receive power and/or data from a data acquisition system.

When not connected to a sensor, the inputs to the sensor signal transmitters are open and an operator is not fully able to determine the operability of the system.

Conventionally, one method for testing and validating operation of the sensor signal transmitters is to electronically couple the actual sensors mounted to the various rotatable components directly to the sensor signal transmitter assemblies. However, this method may not be practical or applicable when the signal transmitter assemblies are off-shaft such as during assembly, test or repair and/or when the turbomachine is non-operational. Another method for testing and validating operation of the sensor signal transmitters off-shaft includes placing an actual sensor on each input or at each terminal pair of pins one channel at a time. This can typically only be done while the system is stationary and is not practical for rotating systems. Another known method for simulating sensors is to oppose a rotating system with another data transmission system. Simulated signals are then injected through the opposing data transmission system into the data transmission/recording system be tested.

Although known methods for testing and validating operation of the sensor signal transmitters are generally effective. Continued improvements in systems for testing and validating operation of the sensor signal transmitters would be useful.

### BRIEF DESCRIPTION OF THE INVENTION

Aspects and advantages of the invention are set forth below in the following description, or may be obvious from the description, or may be learned through practice of the invention.

One embodiment of the present invention is a sensor simulator. The sensor simulator includes a first pin that extends through a base. The first pin has a first end portion and a second end portion where the first end portion is configured to be electronically coupled to a positive terminal of a sensor circuit of a sensor signal transmitter. A second pin extends through the base. The second pin has a first end portion and a second end portion where the first end portion is configured to be electronically coupled to a negative terminal of the sensor circuit. The sensor simulator further includes an electronic component having a first wire lead electronically coupled to a second wire lead. The first wire lead is electronically coupled to the second end portion of the first pin and the second wire lead is electronically coupled to the second end portion of the second pin. The electronic component completes the sensor circuit when the sensor simulator plug is electronically coupled to the sensor signal transmitter.

Another embodiment of the present invention is a system for testing rotatable sensor signal transmitters. The system includes a first rotatable sensor signal transmitter having an input connector. The input connector includes a plurality of terminal pairs, each terminal pair including a positive terminal and a negative terminal electronically coupled to a corresponding sensor circuit. A first sensor simulator is electronically coupled to the input connector. The first sensor simulator includes a plurality of pins. The plurality of pins comprise a first pin that includes a first end portion and a second end portion where the first end portion is electronically coupled to the positive terminal of a corresponding terminal pair of the plurality of terminal pairs. The first sensor simulator also includes a second pin having a first end portion and a second end portion where the first end portion is electronically coupled to the negative terminal of the same terminal pair as the first pin. The first sensor simulation further includes an electronic component. The electronic component includes a first wire lead that is electronically coupled to a second wire lead where the first wire lead is electronically coupled to the second end portion of the first pin and the second wire lead is electronically coupled to the second end portion of the second pin. The electronic component is one of a thermocouple or a resistor.

Those of ordinary skill in the art will better appreciate the features and aspects of such embodiments, and others, upon review of the specification.

### BRIEF DESCRIPTION OF THE DRAWINGS

A full and enabling disclosure of the present invention is set forth more particularly in the remainder of the specification, including reference to the accompanying figures, in which:
FIG. 1 provides a simplified cross sectioned side view of an exemplary slip ring assembly or a telemetry system coupled to one end of a rotatable or rotor shaft in an on-shaft configuration;
FIG. 2 is an enlarged simplified view of an exemplary sensor signal transmitter according to various embodiments of the present invention;
FIG. 3 is a perspective view of a front or connection side of a portion of an exemplary sensor simulator for testing a sensor signal transmitter;
FIG. 4 a perspective view of a back side of the sensor simulator as shown in FIG. 3, according to one embodiment of the present invention;
FIG. 5 is a perspective view of a back side of the sensor simulator as shown in FIG. 3, according to one embodiment of the present invention;
FIG. 6 is a side view of an exemplary electronic component according to various embodiments of the present invention;
FIG. 7 is a perspective view of the sensor simulator as shown in FIG. 3, including a plurality of resistors according to one embodiment of the present invention;
FIG. 8 provides a back side view of the sensor simulator as shown in FIG. 3, including a plurality of resistors as shown in FIG. 7;
FIG. 9 is a side view of an exemplary electronic component according to various embodiments of the present invention;
FIG. 10 is a perspective view of the sensor simulator as shown in FIG. 3, including a plurality of thermocouples as shown in FIG. 9, according to one embodiment of the present invention;
FIG. 11 provides a back side view of the sensor simulator as shown in FIG. 3, including a plurality of thermocouples as shown in FIG. 9;
FIG. 12 provides back side perspective views of a pair of sensor simulators as shown in FIGS. 7 and 11, where a first sensor simulator is configured to simulate a plurality of thermal sensors and a second sensor simulator is configured to simulate a plurality of strain sensors, according to one embodiment of the present invention; and
FIG. 13 is a perspective view of a forward portion of a carrier shaft as shown in FIG. 1 including a plurality of sensor simulators as shown in FIG. 12, according to one embodiment of the present invention.

### DETAILED DESCRIPTION OF THE INVENTION

Each example is provided by way of explanation of the invention, not limitation of the invention. In fact, it will be apparent to those skilled in the art that modifications and variations can be made in the present invention without departing from the scope or spirit thereof. For instance, features illustrated or described as part of one embodiment may be used on another embodiment to yield a still further embodiment. Thus, it is intended that the present invention cover such modifications and variations as come within the scope of the appended claims and their equivalents.

The detailed description uses numerical and letter designations to refer to features in the drawings. Like or similar designations in the drawings and description have been used to refer to like or similar parts of the invention. As used herein, the terms "first", "second", and "third" may be used interchangeably to distinguish one component from another and are not intended to signify location or importance of the individual components.

The terms "upstream" and "downstream" refer to the relative direction with respect to fluid flow in a fluid pathway. For example, "upstream" refers to the direction from which the fluid flows, and "downstream" refers to the direction to which the fluid flows. The term "radially" refers to the relative direction that is substantially perpendicular to an axial centerline of a particular component, and the term "axially" refers to the relative direction that is substantially parallel and/or coaxially aligned to an axial centerline of a particular component.

Although exemplary embodiments of the present invention will be described generally in the context of a sensor simulator and system for testing rotatable sensor signal transmitters for a turbomachine for purposes of illustration, one of ordinary skill in the art will readily appreciate that embodiments of the present invention may be applied to any machine having a rotating shaft and sensors connected thereto.

Therefore, the specification is not intended to be limited to a sensor simulator and system for testing rotatable sensor signal transmitters for a turbomachine unless otherwise specified in the claims.

Embodiments of the present invention provide a sensor simulator and a system for testing a rotatable sensor signal transmitter that includes the sensor simulator. The sensor simulator is a tool for simulating rotating instrumentation or sensors such as rotatable thermocouples and/or strain gauges coupled to various rotatable components of a turbomachine. The sensor simulator electronically simulates the sensor. The sensor simulator is installed or electronically coupled to the sensor signal transmitter. The sensor simulator allows the sensor signal transmitter to be tested, inspected, and/or validated for proper operation on or off-shaft. The sensor simulator allows a sensor circuit of the sensor signal transmitter to be completed and accurately represents the electrical properties of an actual sensor.

The primary component of the sensor simulator is an electronic component such as a thermocouple or resistor that simulates and/or has the same electrical properties as a corresponding sensor. For channels or sensor circuits of the sensor signal transmitter that are configured to acquire strain data using a resistive-based strain gage, the sensor simulator is terminated via precision resistors of equivalent resistance to the resistive-based strain gage. For channels or sensor circuits of the sensor signal transmitter that are configured to acquire temperature using a thermocouple, the sensor simulator is terminated to a thermocouple of equivalent type (per ANSI definition).

The sensor simulator may be configured to simulate any sensor type such thermal resistance, pressure, acceleration or other sensor types by changing the electronic component. Each conductor or lead of the electronic component or simulated sensor may be terminated to a pin or socket that is designed to fit in a printed circuit board or other dielectric material. The pins or sockets may crimp onto the leads of the simulated sensor, they made be soldered, or they may be welded. The pins or sockets are installed into the printed circuit board or equivalent dielectric material in a pattern that is consistent with the pattern of the input on the data transmission/recording device.

During operation of a turbomachine, various rotatable components such as compressor rotor blades, turbine rotor blades, rotor shaft and various other rotatable components are exposed to potentially life limiting thermal and/or mechanical stresses. As a result, it is generally desirable to monitor various operating parameters such as temperature, velocity, stress, strain, vibrations, and/or other characteristics of the rotating components which may allow for detection of abnormalities, allow for adjustments to repair or maintenance schedules, and/or other actions to enhance operation and/or efficiency of the turbomachine such as the gas turbine.

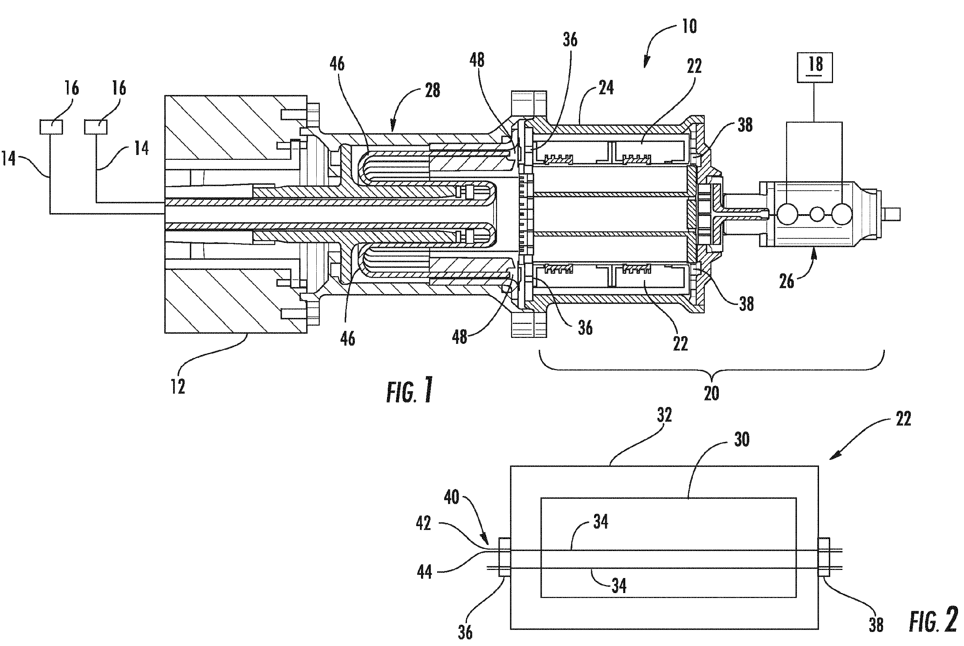

Referring now to the drawings, wherein like numerals refer to like components, FIG. 1 illustrates a slip ring or a telemetry system 10 coupled to one end of a rotatable or rotor shaft 12 or in an on-shaft configuration. In order to monitor operating parameters of the turbomachine and/or conditions at the various rotatable components, it is necessary to collect data related to the various operating parameters and/or conditions such as temperature, velocity, stress, strain and/or vibrations. This data is provided as sensor signals 14 that are generated by rotatable sensors 16 or other electronic instrumentation that is coupled to the various rotatable components (not shown) and collected by a data acquisition system 18 that is positioned off-shaft or is stationary with respect to the rotor shaft 12. The sensors 16 generally comprise thermal sensors such as thermocouples and/or thermal resistance sensors and strain sensors such as strain gauges. The sensor signals 14 are transmitted from the rotating rotor shaft 12 to the data acquisition system 18 via a slip ring or telemetry system 20.

The slip ring or a telemetry system 20 generally includes a plurality of sensor signal transmitters 22 annularly arranged within a carrier shaft 24 that is configured to be coupled to the rotor shaft 12. The slip ring or a telemetry system 20 may also include a slip ring assembly 26 that is electronically coupled to the plurality of sensor signal transmitters 22 and the data acquisition system 18. The slip ring or a telemetry system 20 may be coupled to the rotor shaft 12 via a wire barrel 28 which is configured for routing wire bundles from the sensors 16 out of the rotor shaft 12.

FIG. 2 provides an enlarged simplified view of an exemplary sensor signal transmitter 22. As shown in FIG. 2, the exemplary sensor signal transmitter 22 generally includes at least one circuit board 30 encased within an outer housing 32. The circuit board(s) 30 define various channels or sensor circuits 34. Each sensor circuit 34 is electronically coupled to an input connector 36 such as a multi-pin connector and an output connector 38. The input connector 36 includes a plurality of terminal pairs 40. Each terminal pair 40 includes a positive terminal 42 and a negative terminal 44 electronically coupled to a corresponding sensor circuit 34. At least one of the sensor signal transmitters 22 may be configured to receive and/or process sensor signals from thermal sensors such as thermo couples or thermal resistance sensors. At least one of the sensor signal transmitters 22 may be configured to receive and/or process sensor signals from strain sensors such as strain gauges, accelerometers, or pressure gauges.

The sensor signal transmitters 22 may comprise hardwired logic, a processor, microprocessor, controller, microcontroller, or other embedded circuitry adapted in any suitable manner to provide the desired functionality. For instance, one or more processors may be adapted to provide the described functionality by responding to commands sent by the user through control software. However, the sensor signal transmitters 22 discussed herein are not limited to any particular hardware or software architecture or configuration, and a different sensor signal transmitters 22 may be used for each type of sensor 16 being used. For example, as will be understood by those of ordinary skill in the art without required additional detailed discussion, some systems and methods set forth and disclosed herein may also be implemented by hardwired logic or other circuitry, including, but not limited to, application-specific circuits. Of course, various combinations of computer-executed software and hardwired logic or other circuitry may be suitable as well.

As shown in FIG. 1, when the sensor signal transmitters 22 are mounted to the rotor shaft 12 in an on-shaft configuration, the sensors 16 are electronically coupled to the sensor signal transmitter 22 via a plurality of corresponding wires or wire bundles 46 and/or connectors 48. Each wire bundle 46 and/or connector 48 is coupled to a corresponding input connector 36. In this configuration, the various sensor signal transmitters 22 and/or the sensors 16 may be tested and/or calibrated for example, via the data acquisition system 18 during operation of the turbomachine. However, when the sensor signal transmitters 22 are decoupled from the rotor shaft 12 and the wire bundles 46 and/or connectors 48 are decoupled from the sensors 14, test and/or verification of the various sensor signal transmitter assemblies 22 becomes challenging and time consuming.

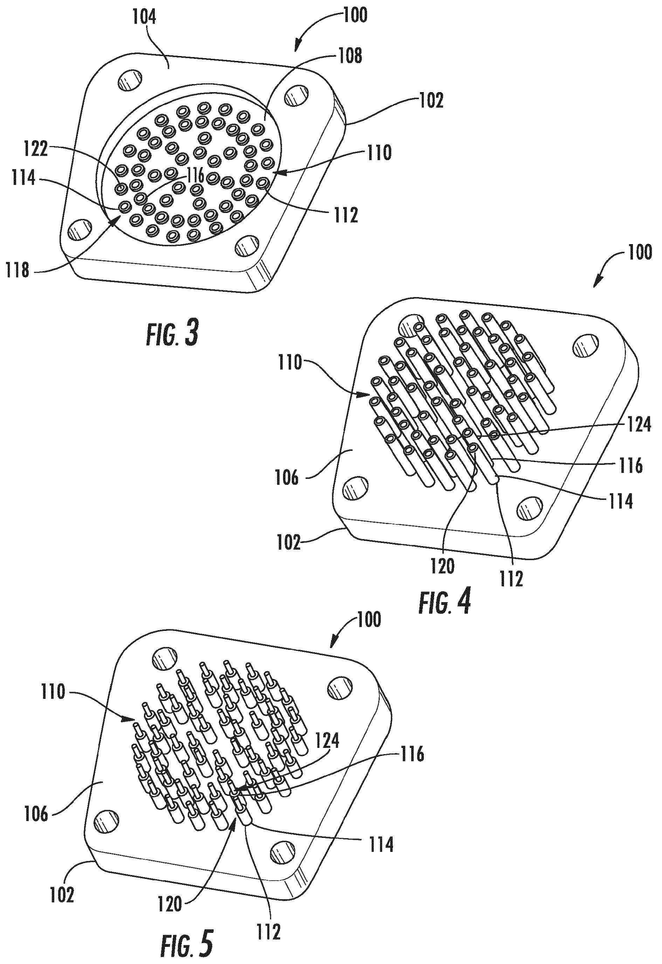

FIG. 3 provides a perspective view of a front or connection side of a portion of an exemplary sensor simulator 100 for testing the sensor signal transmitters 22. FIG. 4 provides a perspective view of a back side of the sensor simulator 100 as shown in FIG. 3, according to one embodiment of the present invention. FIG. 5 provides a perspective view of a back side of the sensor simulator 100 as shown in FIG. 3, according to one embodiment of the present invention. As shown in FIGS. 3, 4 and 5, the sensor simulator 100 includes a base 102 having a first side 104 (FIG. 3) and an opposing back side 106 (FIGS. 4 and 5). The base 102 may be formed from any suitable electrically insulating material such as but not limited to a glass epoxy laminate. As shown in FIG. 3, a recess or depression 108 may be formed on the front side 104.

In various embodiments, as shown in FIGS. 3, 4 and 5, a plurality of pins 110 extend generally axially through corresponding pin holes 112 defined within the base 102. In one embodiment, as shown in FIGS. 3, 4 and 5, the plurality of pins 110 includes a first pin 114 and a second pin 116 that extend through the base 102. The first pin 114 may be electrically insulated from the second pin 116 via the material of the base 102. As shown in FIGS. 3, 4 and 5 collectively, the first pin 114 includes a first end portion 118 and a second end portion 120.

As shown in FIG. 3, the first end portion 118 may extend at least partially through the first side 104 of the base 102. In particular embodiments, the first end portion 118 is disposed within the recces 108. The first end portion 118 is configured to be electronically coupled to one of the positive terminal 42 or negative terminal 44 of a corresponding sensor circuit 34 of a sensor signal transmitter 22. For example, the first end portion 118 may be formed to include or define a female receptacle (as shown) or a male terminal or tip. In particular embodiments, the second end portion 120 may be formed to include or define a female receptacle (FIG. 4) or a male terminal or tip (FIG. 5).

As shown in FIGS. 3, 4 and 5 collectively, the second pin 116 includes a first end portion 122 and a second end portion 124. As shown in FIG. 3, the first end portion 122 may extend at least partially through the first side 104 of the base 102. In particular embodiments, the first end portion 122 is disposed within the recces 108. The first end portion 122 is configured to be electronically coupled to one of the positive terminal 42 or negative terminal 44 of the same sensor circuit 34 as the first pin 114, thus completing the sensor circuit 34. For example, the first end portion 122 may be formed to include or define a female (as shown) or male receptacle. In particular embodiments, the second end portion 124 may be formed to include or define a female receptacle (FIG. 4) or a male terminal or tip (FIG. 5).

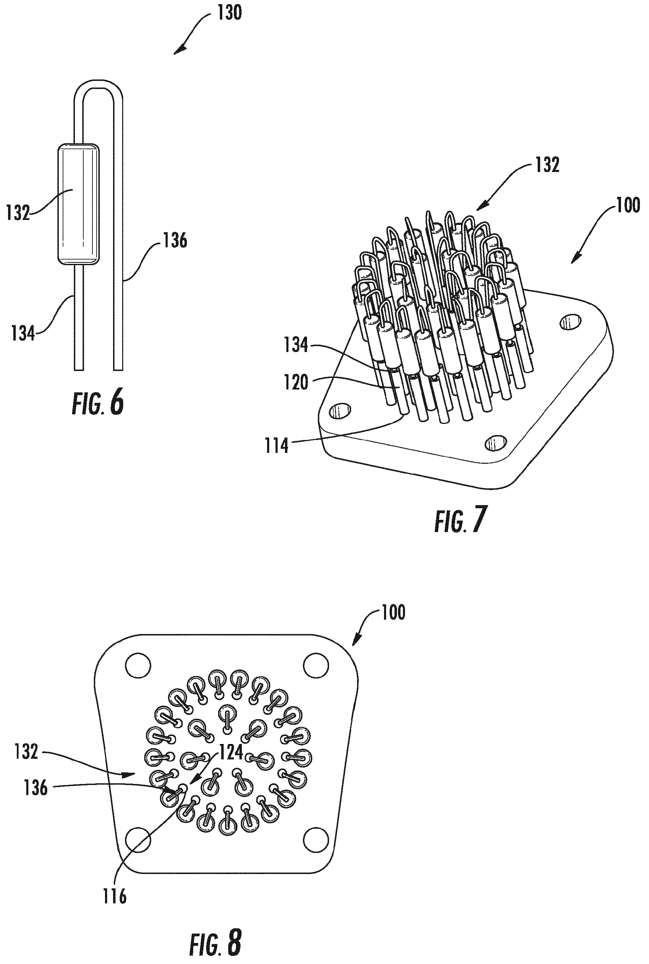

In particular embodiments, the sensor simulator 100 includes a plurality of electronic components. Each electronic component electronically couples two or more of the plurality of pins 110 and simulates a particular sensor type. For example, FIG. 6 provides a side view of an exemplary electronic component 130 according to various embodiments of the present invention.

In one embodiment, as shown in FIG. 6, the electronic component 130 comprises a resistor 132. The resistor 132 includes a first wire lead 134 that is electronically coupled to a second wire lead 136 via the resistor 132. In various embodiments, the resistor 132 has a resistance that is equivalent to a predefine resistance of a resistive-based strain gage sensor that is mounted to a rotatable component of a turbomachine.

FIG. 7 provides a perspective view of the sensor simulator 100 including a plurality of the resistors 132 according to one embodiment of the present invention. FIG. 8 provides a back side view of the sensor simulator 100 including a plurality of the resistors 132 as shown in FIG. 7. As shown in FIG. 7, the first wire lead 134 is electronically coupled to the second end portion 120 of the first pin 114. As shown in FIG. 8, the second wire lead 136 is electronically coupled to the second end portion 124 of the second pin 116, thus completing the sensor circuit 34 when the sensor simulator 100 is electronically coupled to the input connector 36. In this configuration, as shown in FIGS. 6-8, the sensor simulator 100 simulates multiple strain sensors being connected to the sensor signal transmitter 22, thus allowing for test, verification and/or calibration of the sensor signal transmitter 22 off-shaft.

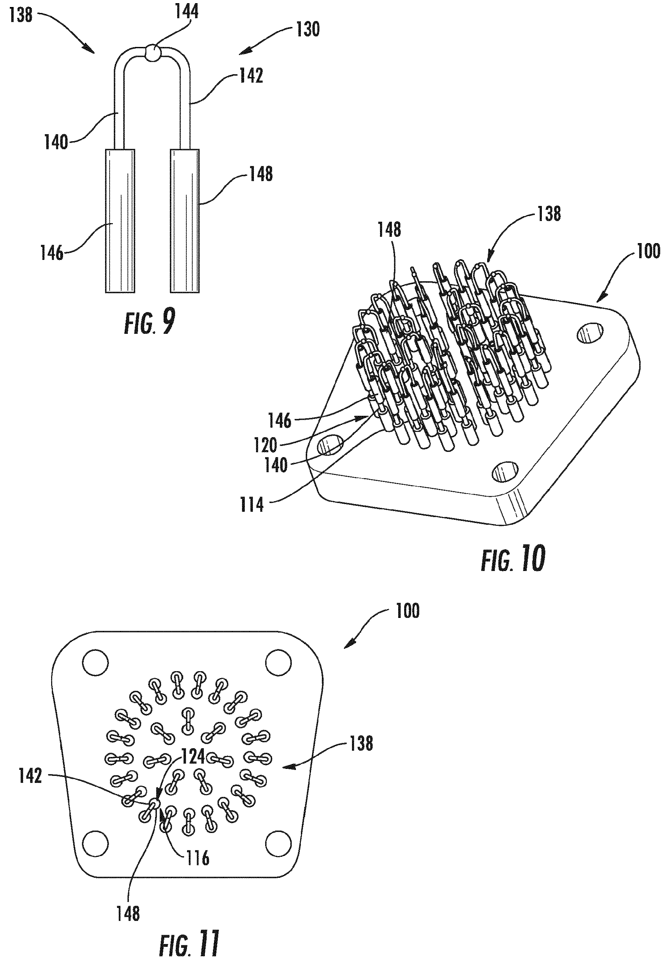

FIG. 9 provides a side view of an exemplary electronic component 130 according to various embodiments of the present invention. In one embodiment, as shown in FIG. 9, the electronic component 130 comprises a thermocouple 138. The thermocouple 138 includes a first wire lead 140 that is electronically coupled to a second wire lead 142 to create a thermocouple junction 144. The first and second lead wires 140, 142 may be made from any suitable material. For example, in one embodiment, the first lead wire 140 comprises Chromel and the second lead wire 142 comprises Alumel. In particular embodiments, a relationship between temperature and voltage of the thermocouple 138 is substantially equivalent to a relationship between temperature and voltage of a thermocouple or thermal sensor used to sense internal temperatures within a turbomachine such as a gas turbine.

FIG. 10 provides a perspective view of the sensor simulator 100 including a plurality of the thermocouples 138 according to one embodiment of the present invention. FIG. 11 provides a back side view of the sensor simulator 100 including a plurality of the thermocouples 138 as shown in FIG. 10. As shown in FIG. 10, the first wire lead 140 is electronically coupled to the second end portion 120 of the first pin 114. As shown in FIG. 11, the second wire lead 142 is electronically coupled to the second end portion 124 of the second pin 116, thus completing the sensor circuit 34 when the sensor simulator 100 is electronically coupled to the input connector 36 of the sensor signal transmitter 22. In one embodiment, as shown in FIGS. 9 and 10, the first lead wire 140 may be electronically coupled to the second end portion 120 of the first pin 114 via a first crimp socket 146 and the second lead wire 142 is electronically coupled to the second end portion 124 of the second pin 116 via a second crimp socket 148. In this configuration, as shown in FIGS. 9-11, the sensor simulator 100 simulates multiple thermal sensors being connected to the sensor signal transmitter 22, thus allowing for test, verification and/or calibration of the sensor signal transmitter 22 off-shaft.

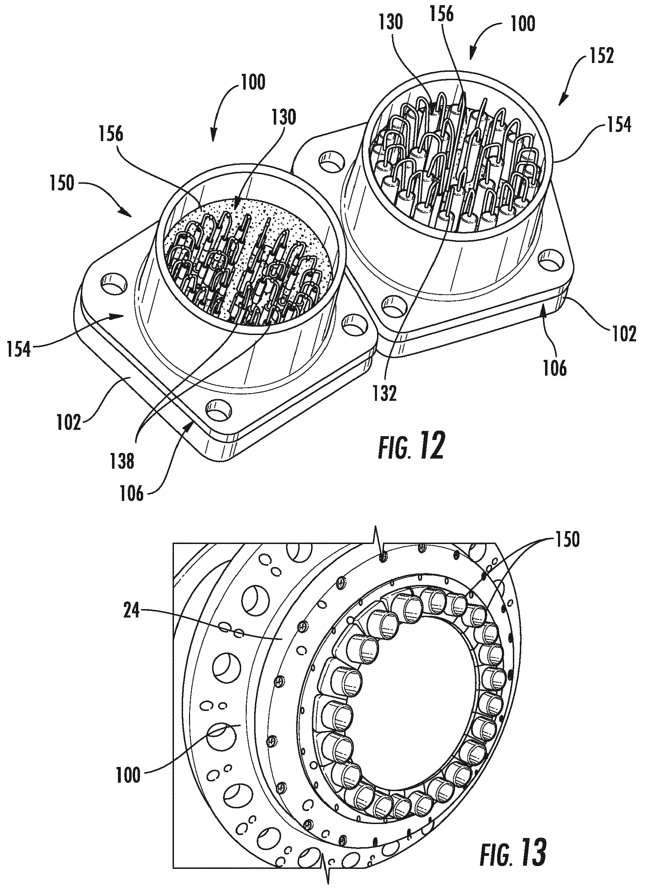

FIG. 12 provides a back side perspective view of a pair of sensor simulators 100 where a first sensor simulator 150 is configured to simulate a plurality of thermal sensors and a second sensor simulator 152 is configured to simulate a plurality of strain sensors. In particular embodiments, as shown in FIG. 12, the sensor simulator 100 may include a shell 154 that is coupled to the back side 106 of the base 102. The shell 154 circumferentially surrounds the electronic components 130. In particular embodiments, the electronic components 130 such are potted within the shell 154 using a suitable potting material 156 for electronics such as an epoxy.

FIG. 13 provides a perspective view of a forward portion of the carrier shaft 24 as shown in FIG. 1 according to one embodiment of the present invention. As shown in FIG. 13, a plurality of the sensor simulators 100 may be electronically coupled to the plurality of sensor signal transmitters 22 encased within the carrier shaft 24. For example, in particular embodiments, a plurality of the sensor simulators 100 configured to simulate a plurality of thermal sensors as shown in FIG. 10, and a plurality of sensor simulators 100 configured to simulate a plurality of strain gauge sensors as shown in FIG. 10, are coupled to corresponding input connectors of the various sensor signal transmitters 22, thus allowing for test, verification and/or calibration of the plurality of sensor signal transmitters 22 without requiring connection to the actual sensors 16.

This written description uses examples to disclose the invention and also to enable any person skilled in the art to practice the invention, including making and using any devices or systems and performing any incorporated methods. The patentable scope of the invention is defined by the claims, and may include other examples that occur to those skilled in the art. Such other and examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A sensor simulator, comprising:
   a first pin that extends through a base, the first pin having a first end portion and a second end portion, wherein the first end portion is configured to be electronically coupled to a positive terminal of a sensor circuit of a sensor signal transmitter;
   a second pin that extends through the base, the second pin having a first end portion and a second end portion, wherein the first end portion is configured to be electronically coupled to a negative terminal of the sensor circuit;
   an electronic component having a first wire lead electronically coupled to a second wire lead, wherein the first wire lead is electronically coupled to the second end portion of the first pin and the second wire lead is electronically coupled to the second end portion of the second pin, wherein the electronic component completes the sensor circuit.
2. The sensor simulator as in clause 1, further comprising a shell coupled to a back side of the base, wherein the shell circumferentially surrounds the electronic component.
3. The sensor simulator as in any preceding clause, wherein the electronic component is potted within the shell.
4. The sensor simulator as in any preceding clause, wherein the electronic component is a resistor.
5. The sensor simulator as in any preceding clause, where the resistor has a resistance that is equivalent to a predefine resistance of a resistive-based strain gage.
6. The sensor simulator as in any preceding clause, wherein the electronic component is a thermocouple.
7. The sensor simulator as in any preceding clause, wherein a relationship between temperature and voltage of the thermocouple is substantially equivalent to a relationship between temperature and voltage of a thermocouple used to sense internal temperatures within a gas turbine.
8. The sensor simulator as in any preceding clause, wherein the first lead wire comprises Chromel and the second lead wire comprises Alumel.
9. The sensor simulator as in any preceding clause, wherein the first lead wire is electronically coupled to the second end portion of the first pin via a first crimp socket and the second lead wire is electronically coupled to the second end portion of the second pin via a second crimp socket.
10. A system for testing rotatable sensor signal transmitters, comprising:
   a first rotatable sensor signal transmitter having an input connector, the input connector having a plurality of terminal pairs, each terminal pair including a positive terminal and a negative terminal electronically coupled to a corresponding sensor circuit;
   a first sensor simulator electronically coupled to the input connector, the first sensor simulator including a plurality of pins, the plurality of pins comprising:
      a first pin that includes a first end portion and a second end portion, wherein the first end portion is electronically coupled to the positive terminal of a corresponding terminal pair of the plurality of terminal pairs;
      a second pin that includes a first end portion and a second end portion, wherein the first end portion is electronically coupled to the negative terminal of the same terminal pair as the first pin; and
      an electronic component having a first wire lead electronically coupled to a second wire lead, wherein the first wire lead is electronically coupled to the second end portion of the first pin and the second wire lead is electronically coupled to the second end portion of the second pin, wherein the electronic
   component completes the sensor circuit, wherein the electronic component is one of a thermocouple or a resistor.
11. The system as in any preceding clause, wherein the sensor simulator includes a shell that circumferentially surrounds the electronic component and the electronic component is potted within the shell.
12. The system as in any preceding clause, wherein the electronic component is a resistor having a resistance that is equivalent to a predefine resistance of a resistive-based strain gage.
13. The system as in any preceding clause, wherein the electronic component is a thermocouple having a temperature and voltage relationship that is substantially equivalent to a temperature and voltage relationship of a thermocouple used to sense internal temperatures within a gas turbine.
14. The system as in any preceding clause, wherein the first lead wire comprises Chromel and the second lead wire comprises Alumel.
15. The system as in any preceding clause, wherein the first lead wire is electronically coupled to the second end portion of the first pin via a first crimp socket and the second lead wire is electronically coupled to the second end portion of the second pin via a second crimp socket.
16. The system as in any preceding clause, further comprising:
   a second rotatable sensor signal transmitter having an input connector, the input connector having a plurality of terminal pairs, each terminal pair including a positive terminal and a negative terminal electronically coupled to a corresponding sensor circuit;
   a second sensor simulator electronically coupled to the input connector, the second sensor simulator including a plurality of pins, the plurality of pins comprising:
      a first pin that includes a first end portion and a second end portion, wherein the first end portion is electronically coupled to the positive terminal of a corresponding terminal pair of the plurality of terminal pairs;
      a second pin that includes a first end portion and a second end portion, wherein the first end portion is electronically coupled to the negative terminal of the same terminal pair as the first pin; and
      an electronic component having a first wire lead electronically coupled to a second wire lead, wherein the first wire lead is electronically coupled to the second end portion of the first pin and the second wire lead is electronically coupled to the second end portion of the second pin, wherein the electronic component completes the sensor circuit, wherein the electronic component is one of a thermocouple or a resistor.
17. The system as in any preceding clause, wherein the electronic component of the first sensor simulator is a thermocouple and the electronic component of the second sensor simulator is a resistor.
18. The system as in any preceding clause, wherein the thermocouple has a temperature and voltage relationship that is substantially equivalent to a temperature and voltage relationship of a thermocouple used to sense internal temperatures within a gas turbine.
19. The system as in any preceding clause, wherein the resistor has a resistance that is equivalent to a predefine resistance of a resistive-based strain gage.
20. The system as in any preceding clause, wherein the first lead wire of the electronic component of the first sensor simulator comprises Chromel and the second lead wire comprises Alumel.

## Claims

1. A sensor simulator, comprising:
a first pin that extends through a base, the first pin having a first end portion and a second end portion, wherein the first end portion is configured to be electronically coupled to a positive terminal of a sensor circuit of a sensor signal transmitter;
a second pin that extends through the base, the second pin having a first end portion and a second end portion, wherein the first end portion is configured to be electronically coupled to a negative terminal of the sensor circuit;
an electronic component having a first wire lead electronically coupled to a second wire lead, wherein the first wire lead is electronically coupled to the second end portion of the first pin and the second wire lead is electronically coupled to the second end portion of the second pin, wherein the electronic component completes the sensor circuit.

2. The sensor simulator as in claim 1, further comprising a shell coupled to a back side of the base, wherein the shell circumferentially surrounds the electronic component.

3. The sensor simulator as in claim 2, wherein the electronic component is potted within the shell.

4. The sensor simulator as in claim 1, 2 or 3, wherein the electronic component is a resistor.

5. The sensor simulator as in claim 4, where the resistor has a resistance that is equivalent to a predefined resistance of a resistive-based strain gage.

6. The sensor simulator as in claim 1, 2 or 3, wherein the electronic component is a thermocouple.

7. The sensor simulator as in claim 6, wherein a relationship between temperature and voltage of the thermocouple is substantially equivalent to a relationship between temperature and voltage of a thermocouple used to sense internal temperatures within a gas turbine.

8. A system for testing rotatable sensor signal transmitters, comprising:
a first rotatable sensor signal transmitter having an input connector, the input connector having a plurality of terminal pairs, each terminal pair including a positive terminal and a negative terminal electronically coupled to a corresponding sensor circuit;
a first sensor simulator electronically coupled to the input connector, the first sensor simulator including a plurality of pins, the plurality of pins comprising:
a first pin that includes a first end portion and a second end portion, wherein the first end portion is electronically coupled to the positive terminal of a corresponding terminal pair of the plurality of terminal pairs;
a second pin that includes a first end portion and a second end portion, wherein the first end portion is electronically coupled to the negative terminal of the same terminal pair as the first pin; and
an electronic component having a first wire lead electronically coupled to a second wire lead, wherein the first wire lead is electronically coupled to the second end portion of the first pin and the second wire lead is electronically coupled to the second end portion of the second pin, wherein the electronic component completes the sensor circuit, wherein the electronic component is one of a thermocouple or a resistor.

9. The system as in claim 8, wherein the sensor simulator includes a shell that circumferentially surrounds the electronic component and the electronic component is potted within the shell.

10. The system as in claim 8 or 9, wherein the electronic component is a resistor having a resistance that is equivalent to a predefined resistance of a resistive-based strain gage.

11. The system as in claim 8 or 9, wherein the electronic component is a thermocouple having a temperature and voltage relationship that is substantially equivalent to a temperature and voltage relationship of a thermocouple used to sense internal temperatures within a gas turbine.

12. The system as in claim 11, wherein the first lead wire comprises Chromel and the second lead wire comprises Alumel.

13. The system as in claim 8 or 9, wherein the first lead wire is electronically coupled to the second end portion of the first pin via a first crimp socket and the second lead wire is electronically coupled to the second end portion of the second pin via a second crimp socket.

14. The system as in any of claims 8 to 13, further comprising:
a second rotatable sensor signal transmitter having an input connector, the input connector having a plurality of terminal pairs, each terminal pair including a positive terminal and a negative terminal electronically coupled to a corresponding sensor circuit;
a second sensor simulator electronically coupled to the input connector, the second sensor simulator including a plurality of pins, the plurality of pins comprising:
a first pin that includes a first end portion and a second end portion, wherein the first end portion is electronically coupled to the positive terminal of a corresponding terminal pair of the plurality of terminal pairs;
a second pin that includes a first end portion and a second end portion, wherein the first end portion is electronically coupled to the negative terminal of the same terminal pair as the first pin; and
an electronic component having a first wire lead electronically coupled to a second wire lead, wherein the first wire lead is electronically coupled to the second end portion of the first pin and the second wire lead is electronically coupled to the second end portion of the second pin, wherein the electronic component completes the sensor circuit, wherein the electronic component is one of a thermocouple or a resistor.

15. The system as in claim 14, wherein the electronic component of the first sensor simulator is a thermocouple and the electronic component of the second sensor simulator is a resistor.
